(19) **Europäisches Patentamt / European Patent Office / Office européen des brevets**

(11) **EP 4 617 696 A1**

(12) **EUROPEAN PATENT APPLICATION**
published in accordance with Art. 153(4) EPC

(43) Date of publication:
**17.09.2025 Bulletin 2025/38**

(21) Application number: **23910017.5**

(22) Date of filing: **06.12.2023**

(51) International Patent Classification (IPC):
*G01R 31/52* (2020.01)     *G01R 31/367* (2019.01)
*G01R 31/385* (2019.01)     *G01R 31/387* (2019.01)

(52) Cooperative Patent Classification (CPC):
Y02E 60/10

(86) International application number:
**PCT/CN2023/136860**

(87) International publication number:
**WO 2024/140087 (04.07.2024 Gazette 2024/27)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **27.12.2022   CN 202211691855**

(71) Applicant: **Envision Energy Technology Pte Ltd.**
**079903 Singapore (SG)**

(72) Inventors:
• **GAO, Wenkai**
  **Shanghai 200011 (CN)**
• **XU, Zhonghua**
  **Shanghai 200011 (CN)**
• **YANG, Yang**
  **Shanghai 200011 (CN)**
• **QIAN, Zhenhua**
  **Shanghai 200011 (CN)**
• **SHI, Jinghui**
  **Shanghai 200011 (CN)**

(74) Representative: **Herrero & Asociados, S.L.**
**Cedaceros, 1**
**28014 Madrid (ES)**

(54) **BATTERY ELECTRIC LEAKAGE STATE IDENTIFICATION METHOD AND SYSTEM BASED ON SPATIAL DIFFERENCE**

(57) The present disclosure relates to a method and system for recognizing an electric leakage state of a battery based on spatial difference. The method includes: setting a time length of a time period, selecting a target time period, and setting a reference battery system for each battery system; obtaining balancing charge of each single cell in the battery system under a balancing strategy; and calculating cumulative balancing charge of the battery system during the target time period, obtaining cumulative balancing charge of the reference battery system during the target time period, and recognizing an electric leakage state of the battery system by using a statistical method based on the cumulative balancing charge of the battery system and of the reference battery system during the target time period. Compared with existing technologies, in the present disclosure, based on correlation between the electric leakage state of a single battery and the balancing charge of the single battery, the cumulative balancing charge of the battery system and of the reference battery system in a spatial dimension is researched to recognize the electric leakage state of the battery system, free from influence of balancing, such that the electric leakage state of the battery system may be recognized and warned in advance.

FIG. 1

**Description**

**TECHNICAL FIELD**

The present disclosure relates to the technical field of battery state recognition technology, and more particularly, to a method and system for recognizing an electric leakage state of a battery based on spatial difference.

**BACKGROUND**

To maximize performance of battery packs, balancing control has been widely used in various battery systems, in which active or passive balancing schemes are used to make battery energy tend to be consistent. Existing methods for recognizing electric leakage states are based on inconsistent changes in State of Charge (SOC) of short-circuited cells in series-connected battery pack. The methods are based on an assumption that the battery systems are unbalanced and are effective only when the balancing control is not enabled. After the balancing control is enabled, the state recognition methods may become ineffective because the balancing control may affect SOC inconsistency between cells.

Therefore, it is necessary to propose an electric leakage state recognition scheme free from influence of balancing.

**SUMMARY**

Objectives of the present disclosure are to provide a method and system for recognizing an electric leakage state of a battery based on spatial difference to overcome the shortcomings of the existing technologies.

The objectives of the present disclosure may be achieved through the following technical solutions.

According to a first aspect of the present disclosure, there is provided a method for recognizing an electric leakage state of a battery based on spatial difference, which includes:

setting a time length of a time period, selecting a target time period, and setting a reference battery system for each battery system;
obtaining balancing charge of each single cell in the battery system under a balancing strategy; and
calculating cumulative balancing charge of the battery system during the target time period, obtaining cumulative balancing charge of the reference battery system during the target time period, and recognizing the electric leakage state of the battery system based on the cumulative balancing charge of the battery system and of the reference battery system during the target time period by using a statistical method.

Further, the battery system is a battery system comprised of single cells connected in series, or a battery system comprised of single cells connected in parallel and then connected in series.

Further, the reference battery system of the battery system includes: a battery system having same specification and operating condition as the battery system, a battery system having different specifications but the same operating condition as the battery system, a battery system having the same specification but different operating conditions from the battery system, and a battery system having different specifications and operating conditions from the battery system. When the battery system having different specifications but the same operating condition as the battery system, or the battery system having the same specification but different operating conditions from the battery system, or the battery system having different specifications and operating conditions from the battery system is set as the reference battery system, the reference battery system is provided with a reference coefficient, and the cumulative balancing charge of the reference battery system during the target time period is multiplied by the reference coefficient to obtain a final cumulative balancing charge.

Further, the cumulative balancing charge of the battery system and of the reference battery system during the target time period is calculated by:
obtaining balancing charge of each single cell in the battery system during this time period, and calculating based on the balancing charge of each single cell by using the statistical method to obtain the cumulative balancing charge of the battery system.

Further, the cumulative balancing charge during the target time period is calculated by:
obtaining the balancing charge of each single cell in the battery system during this time period, and determining the maximum balancing charge as the cumulative balancing charge of the battery system.

Further, the cumulative balancing charge during the target time period is calculated by:
obtaining the balancing charge of each single cell in the battery system during this time period, calculating sum of the balancing charge of all the single cells, and determining the sum as the cumulative balancing charge of the battery system.

Further, the cumulative balancing charge during the target time period is calculated by:
obtaining the balancing charge of each single cell in the battery system during this time period, calculating an average value of the balancing charge of all the single cells, and determining the average value as the cumulative balancing charge of the battery system.

Further, the cumulative balancing charge during the target time period is calculated by:
obtaining the balancing charge of each single cell in the battery system during this time period, setting a weight for each single cell in the battery system, multiplying the balancing charge of each single cell by the weight and then totalizing the products, and determining the sum as the cumulative balancing charge of the battery system.

Further, each time when the cumulative balancing charge is calculated, the weight of each single cell is determined according to magnitude of the balancing charge of each single cell during the target time period.

Further, when the battery system enables the balancing strategy, the balancing charge of a single cell is directly obtained; and when the balancing strategy is not enabled, a state parameter of the single cell is obtained, and the balancing charge of the single cell obtained after the balancing strategy is enabled is simulated based on the state parameter.

Further, the recognizing the electric leakage state of the battery system specifically includes: calculating an average value of the cumulative balancing charge of all the reference battery systems during the target time period, calculating a difference value between the cumulative balancing charge during the target time period and the average value, and determining that the battery system is not in an abnormal electric leakage state when the difference value is smaller than a preset first threshold, or otherwise determining that the battery system is in the abnormal electric leakage state.

Further, the recognizing the electric leakage state of the battery system specifically includes: calculating an average value of the cumulative balancing charge of each reference battery system of the battery system during the target time period, calculating a first difference value between the cumulative balancing charge during the target time period and the average value, presetting cumulative balancing charge, calculating a second difference value between the cumulative balancing charge during the target time period and the preset cumulative balancing charge, determining that the battery system is not in an abnormal electric leakage state when the first difference value is smaller than a preset first threshold and the second difference value is smaller than a preset second threshold, or otherwise determining that the battery system is in the abnormal electric leakage state.

Further, the recognizing the electric leakage state of the battery system specifically includes: separately calculating a difference value between the cumulative balancing charge of the battery system during the target time period and the cumulative balancing charge of each reference battery system during the target time period, and determining that the battery system is not in an abnormal electric leakage state when each of the difference values is smaller than a preset third threshold, or otherwise determining that the battery system is in the abnormal electric leakage state.

Further, the recognizing the electric leakage state of the battery system specifically includes: separately calculating a third difference value between the cumulative balancing charge of the battery system during the target time period and the cumulative balancing charge of each reference battery system during the target time period, presetting cumulative balancing charge, calculating a fourth difference value between the cumulative balancing charge during the target time period and the preset cumulative balancing charge, and determining that the battery system is not in an abnormal electric leakage state when each of the third difference values is smaller than a preset third threshold and the fourth difference value is smaller than a preset fourth threshold, or otherwise determining that the battery system is in the abnormal electric leakage state.

Further, when it is unable to obtain the cumulative balancing charge of one reference battery system during the target time period, preset fixed cumulative balancing charge is obtained to serve as the cumulative balancing charge of the reference battery system during the target time period.

Further, when it is unable to obtain the cumulative balancing charge of one reference battery system during the target time period, the reference battery system does not participate in the calculation.

According to a second aspect of the present disclosure, there is provided a system for recognizing an electric leakage state of a battery based on spatial difference, which includes:

a reference setting unit configured to set a reference battery system for each battery system;

a time period setting unit configured to set a time length of a time period and select a target time period;

a balancing charge obtaining unit configured to obtain balancing charge of each single cell in the battery system under a balancing strategy; and

a recognition unit configured to calculate cumulative balancing charge of the battery system during the target time period, obtain cumulative balancing charge of the reference battery system during the target time period and/or preset cumulative balancing charge to serve as an evaluation value, and determine, based on the cumulative balancing charge during the target time period and the evaluation value, whether the battery system has an electric leakage fault.

Compared with the existing technologies, in the present disclosure, based on correlation between electric leakage phenomenon of a single battery and the balancing charge of the single battery, the cumulative balancing charge of the battery system is calculated based on the balancing charge of the single battery, and comparative study is performed on the cumulative balancing charge of the battery system and of the reference battery system in a spatial dimension to recognize the electric leakage state of the battery system, free from influence of balancing, such that the electric leakage state of the battery system may be recognized and warned in advance.

## BRIEF DESCRIPTION OF THE DRAWINGS

FIG. 1 shows a flowchart of a method for recognizing an electric leakage state;
FIG. 2 shows a structural diagram of a system for recognizing an electric leakage state;
FIG. 3 shows cumulative balancing charge of a battery system A and of its reference battery systems B to H during a target time period; and
FIG. 4 shows the cumulative balancing charge of the battery system A and of its reference battery systems B to H during the target time period.

## DETAILED DESCRIPTION

The present disclosure will be described in detail below with reference to the accompanying drawings and specific embodiments. This embodiment is implemented based on the technical solutions of the present disclosure, and provides detailed implementations and specific operation processes. Apparently, the described embodiments are some but not all of the embodiments of the present disclosure. The scope of protection of the present disclosure is not limited to the following embodiments. All other embodiments obtained by those of ordinary skills in the art based on the embodiments of the present disclosure without creative efforts shall fall within the protection scope of the present disclosure.

The term "one embodiment"' or "embodiments" referred to here refers to specific features, structures, or characteristics that may be included in at least one implementation of the present disclosure. In the description of the present disclosure, it should be understood that the terms "first", "second", "third", etc. in the specification, claims, and accompanying drawings of the present disclosure are used to distinguish different objects, rather than to describe a specific order. Furthermore, the terms "comprise" and "have" as well as variants thereof are intended to cover non-exclusive inclusion. For example, processes, methods, systems, products or devices comprising a series of steps or units are not limited to these listed steps or units. Alternatively, other steps or units that are not listed are also comprised, or alternatively, other steps or units inherent to these processes, methods, systems, products or devices are further comprised.

Although this specification provides method operation steps as described in the embodiments or flowcharts, more or fewer operation steps may be included based on conventional or non-creative labor. The order of the steps recited in the embodiments is merely one of the numerous orders of execution of the steps, and does not represent a single order of execution. When actual systems or server products are executed, they may be executed in sequence or in parallel (such as a parallel processor or a multi-thread processing environment) according to the methods shown in the embodiments or the drawings, or the order of execution of the steps without timing restrictions may be adjusted.

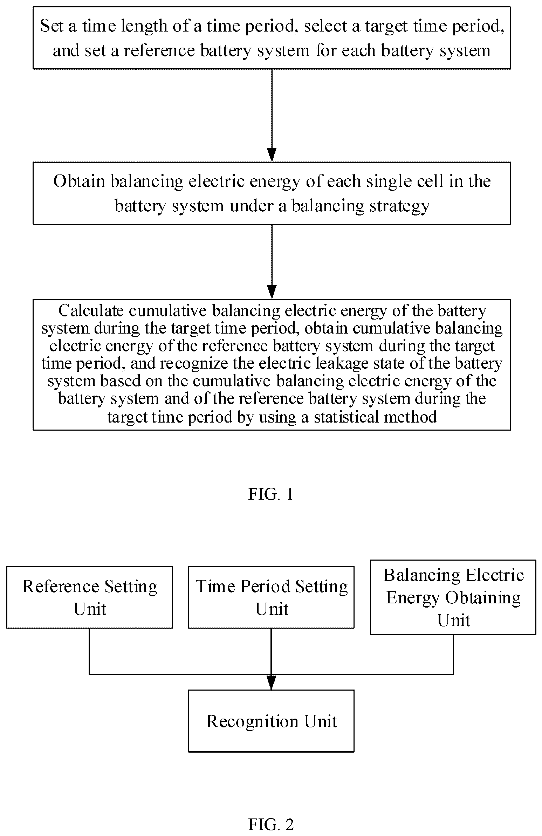

The present disclosure provides a method for recognizing an electric leakage state of a battery based on spatial difference. As shown in FIG. 1, the method includes following steps.

Step S1: setting a time length of a time period, selecting a target time period, and setting a reference battery system for each battery system.

The time length of the time period may be determined according to experience and customized according to time scenario. For example, the time length of the time period may be set to 6 hours, 1 day, 1 week, and 1 month, etc.

The time length of the time period is T, that is, a time interval from 0 to T is one time period, and a time interval from T to 2T is another one time period. In the present disclosure, real-time recognition of the electric leakage state of the battery may be performed. In this application scenario, the target time period is set as a current time period. That is, whenever the time interval is nT, n>0, Steps S2 and S3 are executed to recognize the electric leakage state during the time period from (n-1) T to nT. In the present disclosure, historical data of the battery system may also be obtained, one time period is selected from the historical data as the target time period, and the electric leakage state during this time period is recognized, to analyze the historical state of the battery system.

The battery system is a battery system comprised of single cells connected in series, or a battery system comprised of single cells connected in parallel and then connected in series, such as battery packs, or battery racks, etc.

The reference battery system of the battery system includes: a battery system having same specification and operating condition as the battery system, a battery system having different specifications but the same operating condition as the battery system, a battery system having the same specification but different operating conditions from the battery system, and a battery system having different specifications and operating conditions from the battery system.

(1) Taking a battery system A as a research object, a plurality of battery systems having the same specification and operating condition as the battery system A may be set as the reference battery systems of the battery system A. These reference battery systems and the battery system A have similar operating modes because they have the same specifications and operating conditions, thus the balancing charge of these reference battery systems may be used as a reference to determine whether the balancing charge of the battery system A is abnormal.

(2) Taking the battery system A as the research object, a plurality of battery systems having different specifications but the same operating condition as the battery system A may be set as the reference battery systems of the battery system A.

For example, the battery system A is comprised of 12 Type I cells connected in series, a battery system B is comprised of 24 Type I cells connected in series, and the battery system A has the same operating condition as the battery system B. In this case, the battery system B may be set as the reference battery system of the battery system A. However, considering that the battery system A has different specifications from the battery system B, to eliminate differences, a reference coefficient may be set for the battery system B based on experience. When the battery system A is compared with the battery system B, assuming that the cumulative balancing charge of the battery system A is $a_i$ and the cumulative balancing charge of the battery system B is $b_i$, when a state recognition is made, the cumulative balancing charge $b_i$ of the battery system B should be multiplied by the reference coefficient $\alpha$ to obtain its final cumulative balancing charge, where $0<\alpha<1$.

Similarly, reference coefficients may be set for other battery systems (for example, a battery system C comprised of 24 Type I cells connected in parallel pairwise and then connected in series, and a battery system D comprised of 12 Type II cells connected in series, a self-discharge k value of the Type I cells being $\beta$, and a self-discharge k value of the Type II cells being $\lambda$) having different specifications but the same operating condition as the battery system A, such that the battery systems having different specifications but the same operating condition as the battery system A may be used as the reference systems. It should be noted that for the reference battery systems having the same number of cells and the same series/parallel mode but different cell types, their reference coefficients may be set directly based on the self-discharge k value. For example, after a battery system D is used as the reference battery system, its reference coefficient is set to $\beta/\lambda$.

(3) Taking the battery system A as the research object, a battery system having the same specification but different operating conditions from the battery system A may be set as the reference battery system of the battery system A.

For example, the battery system A operates in a low-temperature environment (such as 15 °C) for a long time, and the battery system B operates in a high-temperature environment (such as 35 °C) for a long time. To eliminate the differences, the reference coefficient needs to set for the battery system B based on experience when the battery system B serves as the reference battery system of the battery system A. Similarly, reference coefficients may be set for other battery systems (the battery system A operates in a lower SOC range such as 20%~60% for a long time, and a battery system E operates in a higher SOC range such as 40%~80% for a long time) having the same specification but different operating conditions from the battery system A, such that the battery systems having the same specification but different operating conditions from the battery system A may serve as the reference systems.

(4) Taking the battery system A as the research object, battery systems having different specifications and operating conditions from the battery system A may also be set as the reference battery systems of the battery system A. In this case, reference coefficients may be set for the reference battery systems based on experience.

Number of the reference battery systems may be set as needed. To avoid a large amount of calculation caused by an excess of battery systems of the same type, the number of the reference battery systems for each battery system may be adjusted according to actual application scenarios and needs. Moreover, two battery systems may serve as reference battery systems for each other or may not serve as the reference battery systems for each other. For example, in this embodiment, the battery system A has eight reference battery systems as below: the battery system B, the battery system C, the battery system D, the battery system E, a battery system F, a battery system G, and a battery system H. The battery system B has eight reference battery systems as below: a battery system I, a battery system J, a battery system K, a battery system L, a battery system M, a battery system N, and a battery system O. The battery system C has six reference battery systems as below: the battery system A, the battery system B, the battery system J, the battery system K, the battery system M, and the battery system N.

In the present disclosure, battery systems having different specifications and operating conditions are introduced to serve as the reference battery systems, which can avoid the occurrence of faults due to concentration of the battery systems having the same specification or operating condition, thus improving effectiveness of the state recognition.

Step S2: obtaining balancing charge of each single cell in the battery system under a balancing strategy.

In a series-connected battery pack, under a passive balancing strategy, when a certain cell/or several cells have higher self-discharge rate, to minimize impacts of this cell on throughput of other cells (for example, to protect the battery, in the process of charging or discharging, the series-connected battery system stops charging and discharging when a certain cell/several cells reach a cut-off voltage. Therefore, to avoid a consequence that the other cells still having remaining charge are unable to continue discharging caused because this cell/several cells reach a discharge cut-off voltage first), in a usual balancing strategy, discharge balancing is carried out for the other cells, such that the system can discharge its charge as much power as possible.

In the above scenario, when a certain cell/several cells have higher self-discharge rate, the other cells need to carry out the discharge balancing according to states of this cell/several cells. Thus it can be seen that the balancing charge is directly related to the electric leakage states of the battery. For one series-connected battery system, its balancing charge depends on the worst cell (the cell having the highest self-discharge rate). Generally, the self-discharge rate of a cell obeys a certain statistical distribution, and the worst cell in each system should also be within this distribution range, thus the corresponding balancing charge also obeys a certain statistical distribution. Therefore, providing a certain number of reference values are given, when there is a cell with electric leakage anomaly in the battery system (the self-discharge rate exceeds a range of fixed value statistically), abnormality may be accurately recognized based on this anomaly.

In the present disclosure, a reference battery system is set for a battery system to be recognized, and statistical analysis is made on the balancing charge of the reference battery system and the balancing charge of the battery system to be recognized, to recognize whether there is any cell with electric leakage anomaly in the battery system during the target time period.

It is to be understood that after the balancing strategy is enabled, the balancing charge of each cell may be directly obtained from a balancing controller, and then the state recognition is made by using the present disclosure. Even if the balancing strategy is not enabled, a state parameter of a single cell may also be obtained, and the balancing charge of the single cell obtained after the balancing strategy is enabled is simulated based on the state parameter, such that the state recognition is made by using the present disclosure. Therefore, the present disclosure is applicable to all battery systems whose balancing charge can be obtained.

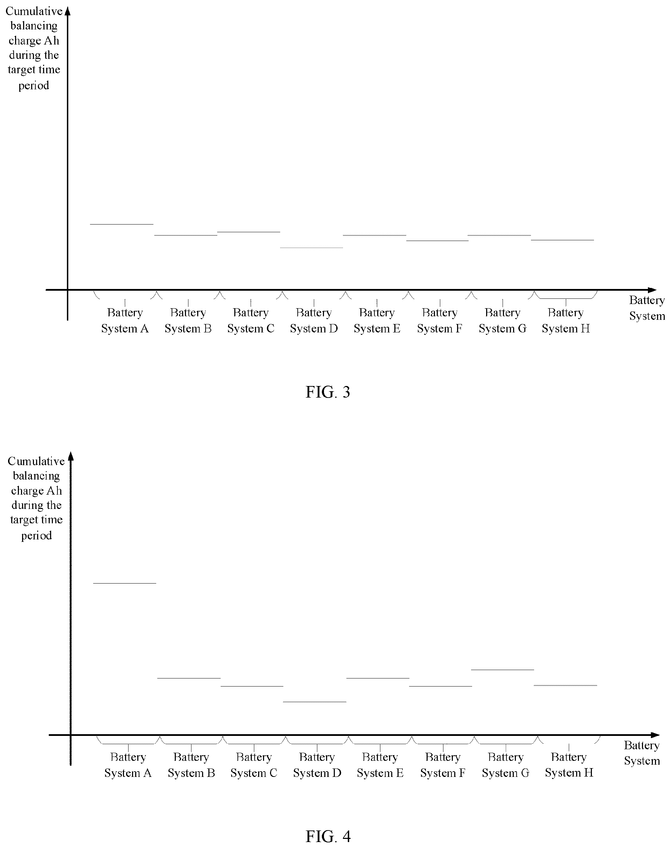

The present disclosure is based on correlation between the balancing charge and an electric leakage fault. As shown in FIG. 3, for the battery system A and its reference battery systems B to H, when the battery system A is normal, there is smaller difference between the cumulative balancing charge of the battery system A and that of these reference battery systems. As shown in FIG. 4, when the battery system A has a fault, there is larger difference between the cumulative balancing charge of the battery system A and that of these reference battery systems. In the present disclosure, the state recognition is made based on the balancing charge, and the state recognition may be made by using Method for Capacity Equalization of Battery Pack disclosed in patent CN103427459A, or by using other balancing strategies based on single-point voltage/state of charge (SOC) alignment, etc. Of course, other balancing strategies may also be used. However, it should be noted that to ensure recognition effects, the balancing method used should not exhibit overbalancing. Even if there exists the overbalancing, degree of the overbalancing should have certain limitation. The core of the limitation is that in a series-connected battery pack, there should be no repeated balancing. That is, for batteries A and B connected in series, when the battery B needs to be balanced, it should not appear that after the battery B is balanced, the battery A needs to be balanced again after calculation, or that after the battery A is balanced, the battery B needs to be balanced again after calculation, and so on, making it unable to converge to a stable balanced state.

Step S3: calculating cumulative balancing charge of the battery system during the target time period, obtaining cumulative balancing charge of the reference battery system during the target time period, and recognizing the electric leakage state of the battery system based on the cumulative balancing charge of the battery system and of the reference battery system during the target time period by using a statistical method.

After it is determined occurrence of the electric leakage fault, which generally includes battery microshort circuiting and high self-discharge rate. Leakage current has different orders of magnitudes under the two types of faults. Therefore, the types of the faults may be determined by obtaining the orders of magnitudes of the leakage current of the battery system during the target time period.

(1) Regarding the cumulative balancing charge of the battery system and of the reference battery system during the target time period, the balancing charge of each single cell in the battery system during this time period may be obtained, and then the balancing charge of each single cell is calculated by using the statistical method, to obtain the cumulative balancing charge of the battery system. Specifically, calculation methods are described as below.

According to the first calculation method, the cumulative balancing charge during the target time period is calculated by:
obtaining the balancing charge of each single cell in the battery system during this time period, and determining the maximum balancing charge as the cumulative balancing charge of the battery system.

For example, in a 4-cell series-connected battery system, during this time period, the balancing charge of Cell 1# is 1Ah, the balancing charge of Cell 2# is 2Ah, the balancing charge of Cell 3# is 3Ah, and the balancing charge of Cell 4# is 0Ah. The balancing charge (the maximum value among the equalized charge quantities of all the four cells, i.e. 3Ah) of Cell 3# is determined as the cumulative balancing charge of the battery system during this time period.

According to the second calculation method, the cumulative balancing charge during the target time period is calculated by:

obtaining the balancing charge of each single cell in the battery system during this time period, calculating sum of the balancing charge of all the single cells, and determining the sum as the cumulative balancing charge of the battery system.

For example, in a 4-cell series-connected battery system, during this time period, the balancing charge of Cell 1# is 1Ah, the balancing charge of Cell 2# is 2Ah, the balancing charge of Cell 3# is 3Ah, and the balancing charge of Cell 4# is 0Ah. The sum (i.e. 6Ah) of the balancing charge of all the four cells is determined as the cumulative balancing charge of the battery system during this time period.

According to the third calculation method, the cumulative balancing charge during the target time period is calculated by:

obtaining the balancing charge of each single cell in the battery system during this time period, calculating an average value of the balancing charge of all the single cells, and determining the average value as the cumulative balancing charge of the battery system.

For example, in a 4-cell series-connected battery system, during this time period, the balancing charge of Cell 1# is 1Ah, the balancing charge of Cell 2# is 2Ah, the balancing charge of Cell 3# is 3Ah, and the balancing charge of Cell 4# is 0Ah. The average value (i.e. 1.5Ah) of the balancing charge of the four cells is determined as the cumulative balancing charge of the battery system during this time period.

According to the fourth calculation method, the cumulative balancing charge during the target time period is calculated by:

obtaining the balancing charge of each single cell in the battery system during this time period, setting a weight for each single cell in the battery system, multiplying the balancing charge of each single cell by the weight and then totalizing the products, and determining the sum as the cumulative balancing charge of the battery system, the formula being expressed as follows:

$$\mathrm{SumE}=\sum_{i}^{n} \omega i * \varepsilon i$$

where $\omega i$ represents the weight of each single cell, $\varepsilon i$ represents the balancing charge of each single cell, and n represents a total number of the single cells in the battery system.

The weights of the single cells may be consistent or may be different. In one aspect, a fixed weight may be set for each single cell, or the weight may be designed as an adaptive variable. For example, each time when calculating the cumulative balancing charge, the weights $\omega$ of the single cells having the maximum and minimum balancing charge during the target time period may be set to 0, and the maximum and minimum values are eliminated. For another example, the weights $\omega$ of N cells having the maximum balancing charge and M cells having the minimum balancing charge may be set to 0, where N>0, and M>0. In other implementations, the weights may be set as needed.

Of course, in other implementations, the cumulative balancing charge may also be calculated by using other calculation methods.

(2) An electric leakage state of the battery system is recognized by using a statistical method based on the cumulative balancing charge of the battery system and of the reference battery system during the target time period. A detailed description is made by taking the battery system A and its reference battery system (the battery system B, the battery system C, and the battery system D) as examples, and following schemes are proposed.

1) The recognizing the electric leakage state of the battery system specifically includes:
calculating an average value of the cumulative balancing charge of all the reference battery systems during the target time period, calculating a difference value between the cumulative balancing charge during the target time period and the average value, and determining that the battery system is not in an abnormal electric leakage state when the difference value is smaller than a preset first threshold, or otherwise determining that the battery system is in the abnormal electric leakage state.

Under this scheme, the electric leakage state is recognized by calculating the difference value between the cumulative balancing charge of the battery system A during the target time period and the average value of the cumulative balancing charge of all the reference battery systems during the target time period, to explore fluctuation of the cumulative balancing charge of the battery system A compared to the reference battery systems. The first threshold may be set by those skilled in the art based on engineering experience, or may be determined in combination with historical data (including the cumulative balancing charge of fault-free battery systems and the cumulative balancing charge of faulty battery systems). For example, in this embodiment, the first threshold is set to 3*sigma, where sigma represents a variance of the cumulative balancing charge of the reference battery systems during the target time period.

2) The recognizing the electric leakage state of the battery system specifically includes:
calculating an average value of the cumulative balancing charge of each reference battery system of the battery system during the target time period, calculating a first difference value between the cumulative balancing charge during the target time period and the average value, presetting cumulative balancing charge, calculating a second difference value between the cumulative balancing charge during the target time period and the preset cumulative balancing charge, determining that the battery system is not in an abnormal electric leakage state when the first difference value is smaller than a preset first threshold and the second difference value is smaller than a preset second threshold, or otherwise determining that the battery system is in the abnormal electric leakage state.

Compared to Scheme 1), under this scheme, there is additionally provided preset cumulative balancing charge, which is set to a fixed value. Synthetic judgment is made in combination with the difference value between the cumulative balancing charge of the battery system A during the target time period and the fixed cumulative balancing charge and the difference value between the cumulative balancing charge of the battery system A during the target time period and the average value of the cumulative balancing charge of the reference battery systems during the target time period, to explore the difference between the cumulative balancing charge of the battery system A and the fixed value and the fluctuation of the cumulative balancing charge of the battery system A compared to the reference battery systems. The preset cumulative balancing charge corresponds to the second threshold. The preset cumulative balancing charge, the first threshold, and the second threshold may be set by those skilled in the art based on engineering experience or may be determined in combination with historical data.

3) The recognizing the electric leakage state of the battery system specifically includes:

separately calculating a difference value between the cumulative balancing charge of the battery system during the target time period and the cumulative balancing charge of each reference battery system during the target time period, and determining that the battery system is not in an abnormal electric leakage state when each of the difference values is smaller than a preset third threshold, or otherwise determining that the battery system is in the abnormal electric leakage state.

Under this scheme, the electric leakage state is recognized by calculating the difference value between the cumulative balancing charge of the battery system A during the target time period and the cumulative balancing charge of each reference battery system during the target time period, to explore fluctuation of the cumulative balancing charge of the battery system A compared to the reference battery systems. The third threshold may be set by those skilled in the art based on the engineering experience, or may be determined in combination with the historical data.

4) The recognizing the electric leakage state of the battery system specifically includes:

separately calculating a third difference value between the cumulative balancing charge of the battery system during the target time period and the cumulative balancing charge of each reference battery system during the target time period, presetting cumulative balancing charge, calculating a fourth difference value between the cumulative balancing charge during the target time period and the preset cumulative balancing charge, and determining that the battery system is not in an abnormal electric leakage state when each of the third difference values is smaller than a preset third threshold and the fourth difference value is smaller than a preset fourth threshold, or otherwise determining that the battery system is in the abnormal electric leakage state.

Compared to Scheme 3), under this scheme, there is additionally provided preset cumulative balancing charge, which is set to a fixed value. Synthetic judgment is made in combination with the difference value between the cumulative balancing charge of the battery system A during the target time period and the fixed cumulative balancing charge and the difference value between the cumulative balancing charge of the battery system A during the target time period and the cumulative balancing charge of each reference battery system during the target time period, to explore the difference between the cumulative balancing charge of the battery system A and the fixed value and the fluctuation of the cumulative balancing charge of the battery system A compared to the reference battery systems. The preset cumulative balancing charge corresponds to the fourth threshold. The preset cumulative balancing charge, the third threshold, and the fourth threshold may be set by those skilled in the art based on the engineering experience or may be determined in combination with the historical data.

For the above schemes 1) to 4), when it is unable to obtain the cumulative balancing charge of one reference battery system during the target time period (for example, loss of the cumulative balancing charge of the reference battery system B during the target time period, or failure to obtain the cumulative balancing charge of the reference battery system B during the target time period), the following scheme may be adopted: the reference battery system B is ignored, that is, the reference battery system B does not participate in the calculation. The following scheme may also be adopted: the preset fixed cumulative balancing charge is obtained to serve as the cumulative balancing charge of the reference battery system (the battery system B) during the target time period.

In the scheme 1), an extremum problem in the reference battery systems is considered, the judgment is based on a mean value of the cumulative balancing charge of a plurality of reference battery systems, which is undoubtedly more stable and representative, avoiding impacts of individual reference battery systems because of their larger/smaller cumulative balancing charge during the target time period. In the scheme 3), the battery system A is compared with each of its reference battery systems, which has higher sensitivity and can avoid misjudgments of the battery system A caused by large-scale electric leakage in the reference battery systems. In the scheme 2) and the scheme 4), recognition conditions are additionally provided, which can avoid misjudgments caused by a single condition and improve accuracy of state recognition.

5) Based on the scheme 1) and the scheme 2), a weight value (different from the weight values involved in the calculation of the cumulative balancing charge) is set for each reference battery system, and then the average value of the cumulative balancing charge of the reference battery systems during the target time period obtained in the scheme 1) and the scheme 2) is changed to a weighted average value. Setting of the weight value may be based on operational reliability of the reference battery systems, similarity of operating conditions and similarity of specifications between the reference battery systems and the battery system A, etc.

6) Based on the scheme 3) and the scheme 4), a confidence coefficient is set for each reference battery system. After it is determined that the battery system A is in the abnormal electric leakage state in the scheme 3) and the scheme 4), the difference value corresponding to each reference battery system is multiplied by the corresponding confidence coefficient, then the products are totalized, and then it is determined whether the battery system A has an electric leakage based on comparison between the results and the set values. Setting of the confidence coefficient may be based on operational reliability of the reference battery systems, similarity of operating conditions and similarity of specifications between the reference battery systems and the battery system A, etc.

7) In other implementations, the above schemes 1) to 6) may be combined arbitrarily. For example, in combination with three schemes, a flag bit may be separately set for each scheme. A value of the flag bit is 1 when a recognition result of the scheme indicates that the battery system is in the abnormal electric leakage state. A value of the flag bit is 0 when the recognition result of the scheme indicates that the battery system is not in the abnormal electric leakage state. Next, the flag bits are separately multiplied by the recognition results, and then the products are totalized to obtain the final recognition result.

Step S4: obtaining the cumulative balancing charge of the battery system during a time period after the target time period, calculating the fluctuation between the cumulative balancing charge during the target time period and the cumulative balancing charge during the time period after the target time period, and verifying the recognition result of the electric leakage state.

It is to be understood that when one time period is selected from the historical data to serve as the target time period, magnitude of leakage current during a subsequent time period and cumulative balancing charge during a subsequent time period may be obtained. When there is an electric leakage problem during the target time period, the magnitude of the leakage current during the subsequent time period and the cumulative balancing charge during the subsequent time period may deteriorate. However, in case of the electric leakage fault resulted from misjudgment due to abnormal data collection, the magnitude of the leakage current during the subsequent time period and the cumulative balancing charge during the subsequent time period may return to normal levels, thus verifying the recognition result of the electric leakage state.

Similarly, in real-time state recognition application scenarios, upon detecting the electric leakage state, the battery system may delay sending an alarm message. Instead, it continues to wait for a subsequent time period, verifies the recognition result based on data such as the magnitude of the leakage current during the subsequent time period and the cumulative balancing charge during the subsequent time period, and then determine the electric leakage state. In this way, misjudgment rate can be reduced. Of course, for a battery system having higher safety requirements, it may send the alarm message without delay once the electric leakage state is detected.

It should be noted that the present disclosure may be implemented in software and/or a combination of software and hardware. For example, the steps described above may be performed by using an application-specific integrated circuit ((ASIC), a general-purpose computer, or any other similar hardware devices, or the steps described above may be performed by programming in a control unit of the battery system. In one embodiment, the software programs of the present disclosure may be executed by a processor to implement the above steps or functions. Similarly, the software programs of the present disclosure (comprising relevant data structures) may be stored in a computer-readable recording medium, for example, a random access memory (RAM), a magnetic or optical driver, a floppy disk, or a similar device.

The present disclosure also provides a system for recognizing an electric leakage state of a battery based on spatial difference. As shown in FIG. 2, the system includes:

a reference setting unit configured to set a reference battery system for each battery system;
a time period setting unit configured to set a time length of a time period and select a target time period;
a balancing charge obtaining unit configured to obtain balancing charge of each single cell in the battery system under a balancing strategy; and
a recognition unit configured to calculate cumulative balancing charge of the battery system during the target time period, obtain cumulative balancing charge of the reference battery system during the target time period and/or preset cumulative balancing charge to serve as an evaluation value, and determine, based on the cumulative balancing charge during the target time period and the evaluation value, whether the battery system has an electric leakage fault.

Operating contents and processes of each unit in the above-mentioned system for recognizing the electric leakage state are the same as the method for recognizing the electric leakage state mentioned above, and thus are not be to be described in detail here.

The above provides a detailed description of the preferred embodiments of the present disclosure. It should be understood that those of ordinary skill in the art can make numerous modifications and changes according to the concept of the present disclosure without creative labor. Therefore, all the technical solutions that can be obtained by those skilled in the art through logical analysis, reasoning or limited experiments according to the concept of the present disclosure on the basis of the existing technologies should fall within the protection scope determined by the claims.

**Claims**

1. A method for recognizing an electric leakage state of a battery based on spatial difference, comprising:

   setting a time length of a time period, selecting a target time period, and setting a reference battery system for each battery system;
   obtaining balancing charge of each single cell in the battery system under a balancing strategy; and
   calculating cumulative balancing charge of the battery system during the target time period, obtaining cumulative balancing charge of the reference battery system during the target time period, and recognizing the electric leakage state of the battery system based on the cumulative balancing charge of the battery system and of the reference battery system during the target time period by using a statistical method.

2. The method for recognizing the electric leakage state of the battery based on spatial difference according to claim 1, wherein the battery system is a battery system comprised of single cells connected in series, or a battery system comprised of single cells connected in parallel and then connected in series.

3. The method for recognizing the electric leakage state of the battery based on spatial difference according to claim 1, wherein the reference battery system of the battery system comprises: a battery system having same specification and operating condition as the battery system, a battery system having different specifications but the same operating condition as the battery system, a battery system having the same specification but different operating conditions from the battery system, and a battery system having different specifications and operating conditions from the battery system; and when the battery system having different specifications but the same operating condition as the battery system, or the battery system having the same specification but different operating conditions from the battery system, or the battery system having different specifications and operating conditions from the battery system is set as the reference battery system, the reference battery system is provided with a reference coefficient, and the cumulative balancing charge of the reference battery system during the target time period is multiplied by the reference coefficient to obtain a final cumulative balancing charge.

4. The method for recognizing the electric leakage state of the battery based on spatial difference according to claim 1, wherein the cumulative balancing charge of the battery system and of the reference battery system during the target time period is calculated by:
   obtaining balancing charge of each single cell in the battery system during this time period, and calculating based on the balancing charge of each single cell by using the statistical method to obtain the cumulative balancing charge of the battery system.

5. The method for recognizing the electric leakage state of the battery based on spatial difference according to claim 4, wherein the cumulative balancing charge during the target time period is calculated by:
   obtaining the balancing charge of each single cell in the battery system during this time period, and determining the maximum balancing charge as the cumulative balancing charge of the battery system.

6. The method for recognizing the electric leakage state of the battery based on spatial difference according to claim 4, wherein the cumulative balancing charge during the target time period is calculated by:
   obtaining the balancing charge of each single cell in the battery system during this time period, calculating sum of the balancing charge of all the single cells, and determining the sum as the cumulative balancing charge of the battery system.

7. The method for recognizing the electric leakage state of the battery based on spatial difference according to claim 4, wherein the cumulative balancing charge during the target time period is calculated by:
   obtaining the balancing charge of each single cell in the battery system during this time period, calculating an average value of the balancing charge of all the single cells, and determining the average value as the cumulative balancing charge of the battery system.

8. The method for recognizing the electric leakage state of the battery based on spatial difference according to claim 4, wherein the cumulative balancing charge during the target time period is calculated by:
   obtaining the balancing charge of each single cell in the battery system during this time period, setting a weight for each single cell in the battery system, multiplying the balancing charge of each single cell by the weight and then totalizing the products, and determining the sum as the cumulative balancing charge of the battery system.

9. The method for recognizing the electric leakage state of the battery based on spatial difference according to claim 8, wherein each time when the cumulative balancing charge is calculated, the weight of each single cell is determined according to magnitude of the balancing charge of each single cell during the target time period.

10. The method for recognizing the electric leakage state of the battery based on spatial difference according to any one of claims 4 to 9, wherein when the battery system enables the balancing strategy, the balancing charge of a single cell is directly obtained; and when the balancing strategy is not enabled, a state parameter of the single cell is obtained, and the balancing charge of the single cell obtained after the balancing strategy is enabled is simulated based on the state parameter.

11. The method for recognizing the electric leakage state of the battery based on spatial difference according to claim 1, wherein the recognizing the electric leakage state of the battery system specifically comprises:
calculating an average value of the cumulative balancing charge of all the reference battery systems during the target time period, calculating a difference value between the cumulative balancing charge during the target time period and the average value, and determining that the battery system is not in an abnormal electric leakage state when the difference value is smaller than a preset first threshold, or otherwise determining that the battery system is in the abnormal electric leakage state.

12. The method for recognizing the electric leakage state of the battery based on spatial difference according to claim 1, wherein the recognizing the electric leakage state of the battery system specifically comprises:
calculating an average value of the cumulative balancing charge of each reference battery system of the battery system during the target time period, calculating a first difference value between the cumulative balancing charge during the target time period and the average value, presetting cumulative balancing charge, calculating a second difference value between the cumulative balancing charge during the target time period and the preset cumulative balancing charge, determining that the battery system is not in an abnormal electric leakage state when the first difference value is smaller than a preset first threshold and the second difference value is smaller than a preset second threshold, or otherwise determining that the battery system is in the abnormal electric leakage state.

13. The method for recognizing the electric leakage state of the battery based on spatial difference according to claim 1, wherein the recognizing the electric leakage state of the battery system specifically comprises:
separately calculating a difference value between the cumulative balancing charge of the battery system during the target time period and the cumulative balancing charge of each reference battery system during the target time period, and determining that the battery system is not in an abnormal electric leakage state when each of the difference values is smaller than a preset third threshold, or otherwise determining that the battery system is in the abnormal electric leakage state.

14. The method for recognizing the electric leakage state of the battery based on spatial difference according to claim 1, wherein the recognizing the electric leakage state of the battery system specifically includes: separately calculating a third difference value between the cumulative balancing charge of the battery system during the target time period and the cumulative balancing charge of each reference battery system during the target time period, presetting cumulative balancing charge, calculating a fourth difference value between the cumulative balancing charge during the target time period and the preset cumulative balancing charge, and determining that the battery system is not in an abnormal electric leakage state when each of the third difference values is smaller than a preset third threshold and the fourth difference value is smaller than a preset fourth threshold, or otherwise determining that the battery system is in the abnormal electric leakage state.

15. The method for recognizing the electric leakage state of the battery based on spatial difference according to any one of claims 11 to 14, wherein when it is unable to obtain the cumulative balancing charge of one reference battery system during the target time period, preset fixed cumulative balancing charge is obtained to serve as the cumulative balancing charge of the reference battery system during the target time period.

16. The method for recognizing the electric leakage state of the battery based on spatial difference according to any one of claims 11 to 14, wherein when it is unable to obtain the cumulative balancing charge of one reference battery system during the target time period, the reference battery system does not participate in the calculation.

17. A system for recognizing an electric leakage state of a battery based on spatial difference, comprising:

a reference setting unit configured to set a reference battery system for each battery system; a time period setting unit configured to set a time length of a time period and select a target time period; a balancing charge obtaining unit configured to obtain balancing charge of each single cell in the battery system under a balancing strategy; and a recognition unit configured to calculate cumulative balancing charge of the battery system during the target time period, obtain cumulative balancing charge of the reference battery system during the target time period and/or preset cumulative balancing charge to serve as an evaluation value, and determine, based on the cumulative balancing charge during the target time period and the evaluation value, whether the battery system has an electric leakage fault.

Set a time length of a time period, select a target time period, and set a reference battery system for each battery system

Obtain balancing electric energy of each single cell in the battery system under a balancing strategy

Calculate cumulative balancing electric energy of the battery system during the target time period, obtain cumulative balancing electric energy of the reference battery system during the target time period, and recognize the electric leakage state of the battery system based on the cumulative balancing electric energy of the battery system and of the reference battery system during the target time period by using a statistical method

FIG. 1

| Reference Setting Unit | Time Period Setting Unit | Balancing Electric Energy Obtaining Unit |

Recognition Unit

FIG. 2

Cumulative
balancing
charge Ah
during the
target time
period

Battery
System A

Battery
System B

Battery
System C

Battery
System D

Battery
System E

Battery
System F

Battery
System G

Battery
System H

Battery
System

FIG. 3

Cumulative
balancing
charge Ah
during the
target time
period

Battery
System A

Battery
System B

Battery
System C

Battery
System D

Battery
System E

Battery
System F

Battery
System G

Battery
System H

Battery
System

FIG. 4

## INTERNATIONAL SEARCH REPORT

| International application No. |
| --- |
| **PCT/CN2023/136860** |

**A.   CLASSIFICATION OF SUBJECT MATTER**

G01R31/52(2020.01)i;  G01R31/367(2019.01)i;  G01R31/385(2019.01)i;  G01R31/387(2019.01)i

According to International Patent Classification (IPC) or to both national classification and IPC

**B.   FIELDS SEARCHED**

Minimum documentation searched (classification system followed by classification symbols)

IPC:G01R31

Documentation searched other than minimum documentation to the extent that such documents are included in the fields searched

Electronic data base consulted during the international search (name of data base and, where practicable, search terms used)

CNABS, CNTXT, CNKI, ENTXTC: 电池, 漏电, 放电, 故障, 短路, 均衡, 平衡, 电量, 容量, BATTERY, CELL, LEAKAGE, DISCHARGE, SHORT, FAULT, BALANCE, CAPACITY, POWER

**C.   DOCUMENTS CONSIDERED TO BE RELEVANT**

| Category* | Citation of document, with indication, where appropriate, of the relevant passages | Relevant to claim No. |
| --- | --- | --- |
| PX | CN 116224149 A (ENVISION ENERGY LIMITED) 06 June 2023 (2023-06-06) <br> claims 1-17 | 1-17 |
| Y | CN 115327406 A (STATE GRID JIANGSU ELECTRIC POWER COMPANY RESEARCH INSTITUTE et al.) 11 November 2022 (2022-11-11) <br> description, paragraphs 64-127, and figures 1-3 | 1-17 |
| Y | CN 112740504 A (BAYERISCHE MOTOREN WERKE AG) 30 April 2021 (2021-04-30) <br> description, paragraphs 24-60, and figures 1-3 | 1-17 |
| A | CN 113848479 A (XI'AN JIAOTONG UNIVERSITY) 28 December 2021 (2021-12-28) <br> entire document | 1-17 |
| A | CN 106802396 A (UNIVERSITY OF SHANGHAI FOR SCIENCE AND TECHNOLOGY) 06 June 2017 (2017-06-06) <br> entire document | 1-17 |
| A | CN 109917297 A (BEIJING JINGWEI HIRAIN TECHNOLOGIES CO., LTD.) 21 June 2019 (2019-06-21) <br> entire document | 1-17 |

☑ Further documents are listed in the continuation of Box C.   ☑ See patent family annex.

| | |
| --- | --- |
| \*    Special categories of cited documents: <br> "A"   document defining the general state of the art which is not considered to be of particular relevance <br> "D"   document cited by the applicant in the international application <br> "E"   earlier application or patent but published on or after the international filing date <br> "L"   document which may throw doubts on priority claim(s) or which is cited to establish the publication date of another citation or other special reason (as specified) <br> "O"   document referring to an oral disclosure, use, exhibition or other means <br> "P"   document published prior to the international filing date but later than the priority date claimed | "T"   later document published after the international filing date or priority date and not in conflict with the application but cited to understand the principle or theory underlying the invention <br> "X"   document of particular relevance; the claimed invention cannot be considered novel or cannot be considered to involve an inventive step when the document is taken alone <br> "Y"   document of particular relevance; the claimed invention cannot be considered to involve an inventive step when the document is combined with one or more other such documents, such combination being obvious to a person skilled in the art <br> "&"   document member of the same patent family |

| Date of the actual completion of the international search | Date of mailing of the international search report |
| --- | --- |
| **26 March 2024** | **28 March 2024** |

| Name and mailing address of the ISA/CN | Authorized officer |
| --- | --- |
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

**EP 4 617 696 A1**

**INTERNATIONAL SEARCH REPORT**

International application No.

**PCT/CN2023/136860**

**C. DOCUMENTS CONSIDERED TO BE RELEVANT**

| Category* | Citation of document, with indication, where appropriate, of the relevant passages | Relevant to claim No. |
|---|---|---|
| A | CN 110376530 A (TSINGHUA UNIVERSITY) 25 October 2019 (2019-10-25)<br>entire document | 1-17 |
| A | CN 111856316 A (HUAWEI TECHNOLOGIES CO., LTD.) 30 October 2020 (2020-10-30)<br>entire document | 1-17 |
| A | CN 115248379 A (GAC AION NEW ENERGY AUTOMOBILE CO., LTD.) 28 October 2022 (2022-10-28)<br>entire document | 1-17 |
| A | CN 115372848 A (CONTEMPORARY AMPEREX TECHNOLOGY CO., LTD.) 22 November 2022 (2022-11-22)<br>entire document | 1-17 |
| A | KR 20210041981 A (LG CHEMICAL LTD.) 16 April 2021 (2021-04-16)<br>entire document | 1-17 |

Form PCT/ISA/210 (second sheet) (July 2022)

EP 4 617 696 A1

**INTERNATIONAL SEARCH REPORT**
Information on patent family members

International application No.

**PCT/CN2023/136860**

| Patent document cited in search report | | | Publication date (day/month/year) | Patent family member(s) | | | Publication date (day/month/year) |
|---|---|---|---|---|---|---|---|
| CN | 116224149 | A | 06 June 2023 | None | | | |
| CN | 115327406 | A | 11 November 2022 | None | | | |
| CN | 112740504 | A | 30 April 2021 | DE | 102018216356 | A1 | 26 March 2020 |
| | | | | KR | 20210040123 | A | 12 April 2021 |
| | | | | KR | 102533462 | B1 | 17 May 2023 |
| | | | | WO | 2020064221 | A1 | 02 April 2020 |
| | | | | EP | 3864734 | A1 | 18 August 2021 |
| | | | | US | 2021396817 | A1 | 23 December 2021 |
| | | | | JP | 2022502990 | A | 11 January 2022 |
| | | | | JP | 7389797 | B2 | 30 November 2023 |
| CN | 113848479 | A | 28 December 2021 | None | | | |
| CN | 106802396 | A | 06 June 2017 | None | | | |
| CN | 109917297 | A | 21 June 2019 | None | | | |
| CN | 110376530 | A | 25 October 2019 | None | | | |
| CN | 111856316 | A | 30 October 2020 | None | | | |
| CN | 115248379 | A | 28 October 2022 | None | | | |
| CN | 115372848 | A | 22 November 2022 | None | | | |
| KR | 20210041981 | A | 16 April 2021 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 103427459 A